(19) Europäisches Patentamt
European Patent Office
Office européen des brevets

(11) **EP 2 363 886 A1**

(12) **EUROPEAN PATENT APPLICATION**

(43) Date of publication:
**07.09.2011 Bulletin 2011/36**

(51) Int Cl.:
***H01L 27/12*** *(2006.01)*

(21) Application number: **10195783.5**

(22) Date of filing: **17.12.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **03.03.2010 FR 1051526**

(71) Applicant: **S.O.I. Tec Silicon on Insulator
Technologies
38190 Bernin (FR)**

(72) Inventors:
• **Mazure, Carlos**
  **38190, BERNIN (FR)**
• **Ferrant, Richard**
  **29770, ESQUIBIEN (FR)**

(74) Representative: **Collin, Jérôme et al
Cabinet Regimbeau
20, rue de Chazelles
75847 Paris Cedex 17 (FR)**

(54) **Data path cell on an SeOI substrate with a buried back control gate beneath the insulating layer**

(57) The invention relates, according to a first aspect, to a data path cell specifically adapted to its environment for use in an integrated circuit produced on a semiconductor-on-insulator substrate comprising a thin layer of semiconductor material separated from a bulk substrate by an insulating layer, the cell comprising an array of field-effect transistors, each transistor having, in the thin layer, a source region ($S_7$), a drain region ($D_7$) and a channel region ($C_7$) which is bounded by the source and drain regions, and further including a front gate control region ($GA_7$) formed above the channel region, characterized in that at least one transistor ($T_7$) has a back gate control region ($GN_2$) formed in the bulk substrate beneath the channel region, the back gate region being able to be biased so as to modify the performance characteristics of the transistor.

**FIG. 3**

EP 2 363 886 A1

**Description**

The field of the invention is that of microelectronics.

The invention relates more particularly to a semiconductor device produced on an SeOI (semiconductor on insulator) substrate based on elementary data path cells.

The design of integrated circuits is based on integrating a plurality of elementary cells having predetermined logic functions. In general, two types of design may be distinguished.

According to the first type of design, a library comprising around a thousand predesigned cells for general usage is employed. These are then referred to as "standard cells".

According to the second type of design, cells specifically adapted to the environment in which they are used are designed. These are then referred to as "data path" cells.

It will be understood that, for a given circuit, the use of data path cells specifically developed for this circuit makes it possible to achieve better performance characteristics (typically in terms of speed, power consumption and footprint). However, the design cost is higher.

Thus, data path cells are typically used only for high-speed circuits requiring optimized performance characteristics, for example for microprocessors. These cells are especially designed so as to produce arithmetic units for which a high repetivity of relatively complex basic functions is observed. Examples that may be mentioned are adders, multipliers, etc.

Improvement in performance (speed, consumption) and miniaturization are ongoing requirements in the field of application of the invention.

The objective of the invention is to meet these requirements and, for this purpose, a first aspect of the invention is a data path cell specifically adapted to its environment for use in an integrated circuit produced on a semiconductor-on-insulator substrate comprising a thin layer of semiconductor material separated from a bulk substrate by an insulating layer, the cell comprising an array of field-effect transistors, each transistor having, in the thin layer, a source region, a drain region and a channel region which is bounded by the source and drain regions, and further including a front gate control region formed above the channel region, characterized in that at least one transistor has a back gate control region formed in the bulk substrate beneath the channel region, the back gate region being able to be biased so as to modify the performance characteristics of the transistor.

Certain preferred, but non-limiting, features of this cell are the following:

- a back gate line connects the back gate regions of a plurality of transistors;
- the back gate line extends into the bulk substrate beneath the insulating layer along a row of transistors ;
- the back gate region is isolated from the bulk substrate by a well of opposite conductivity type; and
- the back gate region has a conductivity of the same type as that of the channel of the transistor.

According to another aspect, the invention relates to an integrated circuit produced on a semiconductor-on-insulator substrate comprising a data path cell according to the first aspect of the invention.

According to yet another aspect, the invention relates to a method of driving a data path cell according to the first aspect of the invention, in which the back gate region is connected to a first potential when the transistor is in the off-state and to a second potential when the transistor is in the on-state.

According to yet another aspect, the invention relates to a method of designing a data path cell in which the cell is specifically adapted to its environment for use in an integrated circuit produced on a semiconductor-on-insulator substrate comprising a thin layer of semiconductor material separated from a bulk substrate by an insulating layer, comprising the steps consisting in:

- reducing the physical width of a transistor of the cell, in order to decrease the capacitance thereof; and
- adding a back control gate to the transistor, said gate being placed in the bulk substrate, in order to increase the conductance thereof when in use in an on-state.

Other features, objects and advantages of the present invention will become more clearly apparent on reading the following detailed description of preferred embodiments thereof, given by way of non-limiting example and with reference to the appended drawings in which:

- Figure 1 shows the possible gain in terms of propagation delay by implementing the invention;
- Figure 2 is a diagram illustrating the production of a back control gate; and
- Figure 3 aims to compare a CMOS data path cell on a bulk substrate with a CMOS data path cell on an SeOI substrate according to one possible embodiment of the first aspect of the invention.

The invention relates to an integrated circuit comprising a plurality of data path cells. Each of the data path cells is specifically developed for this circuit and is consequently highly adapted to its operating environment.

Typically, a data path cell comprises an input stage and an output stage. It may also include one or more intermediate stages connecting the input stage to the output stage.

To maximize the speed of the circuit, various actions may be taken.

Firstly, the length of the electrical connections connecting the data path cells together or the length of the electrical connections connecting the stages of a data path cell together may be shortened. The connections then have a reduced load capacitance and a reduced resistance.

Outward stages may also be provided that have a low impedance. The output stages then have a level of conduction sufficient for rapidly charging the output electrical connection or connections and the input stages of the following data path cell.

This typically imposes the use of large transistors, particularly transistors having a large width.

However, it should be noted that an output stage also constitutes a load (for the input stage or the intermediate stage(s) of the data path cell) which is higher the larger the dimensions of the transistors that make up the output stage. Furthermore, its power consumption, under both static and dynamic conditions, is proportional to its dimensions.

Yet another means of maximizing the speed of a circuit consists in providing low-capacitance input stages. This may be achieved by reducing the dimensions of the input stage of a cell. The load of the preceding cell is thus reduced.

But by reducing the dimensions, there is a risk of this input stage not having a sufficient level of conduction for effectively charging the intermediate stage(s) or the output stage.

Moreover, performance variability may result from excessive miniaturization. In particular, there is then a risk of parallel data path cells having substantially different speeds.

More generally, any stage constitutes both an output stage for the following stage or following cell and an input stage for the preceding stage or preceding cell.

It will therefore be understood that, for each stage, a compromise must be sought between transistors of small dimensions, in order to reduce the capacitance thereof (and therefore reduce the load of the preceding stage or stages) and transistors of large dimensions in order to reduce the resistance thereof (and therefore to charge the following stage or stages effectively).

In the context of the invention, each of the stages consists of a plurality of FET transistors (FET standing for field effect transistor) that are produced on an SeOI substrate, especially on an SOI (silicon on insulator). Each transistor has a source region, a drain region and a channel region that separates the source region from the drain region. The transistor also has a front control gate separated from the channel by a gate dielectric layer.

The invention also proposes to place a back control gate in the bulk substrate facing the channel of at least one transistor.

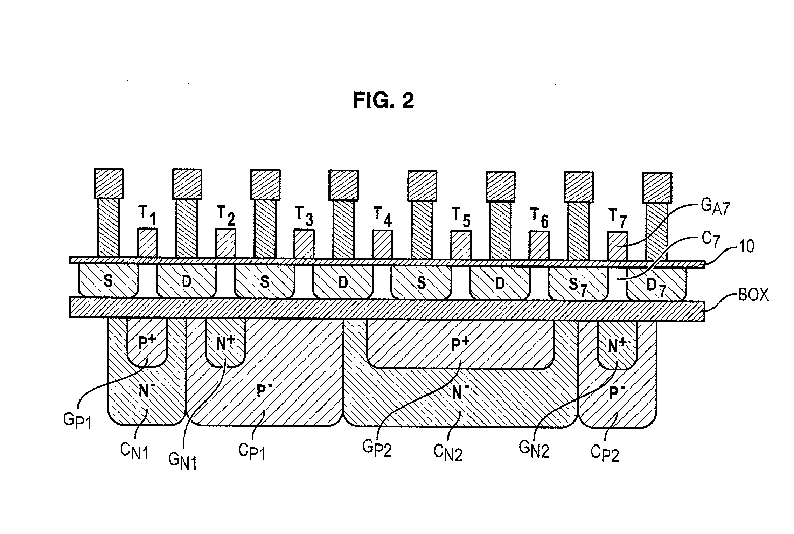

Figure 2 shows a sectional view of a row of nMOS transistors $T_1$-$T_7$ produced on an SeOI substrate. In this sectional view, the insulating layer bears the reference BOX (BOX standing for buried oxide).

In this Figure 2, the channel of the transistors is fully depleted, the source region S and the drain region D both being in contact with the insulating layer BOX.

However, the invention also extends to partially depleted technology in which the source region and the drain region do not extend right into the thin layer. In this case, it should be noted that the back control gate is overall less effective as it is further from the channel region between the source and drain regions.

For the sake of clarity, Figure 2 shows transistors having the same dimensions.

However, Figure 2 is given purely as an illustration. In practice, the transistors of the data path cell are not necessarily arranged in rows, they do not necessarily have the same dimensions (including along a given row), they may have an individual back control gate or a common back control gate, the potential applied to the back control gates may or may not be different, etc.

Referring to the transistor $T_7$, this has, in the thin layer of the SeOI substrate, a source region $S_7$, a drain region $D_7$ and a channel region $C_7$ lying between the source and the drain. The transistor $T_7$ further includes a front control gate region $G_{A7}$ conventionally placed in a manner known per se above the channel, a gate dielectric layer 10 being interposed between the front control gate $G_{A7}$ and the channel $C_7$.

The transistor $T_7$ further includes a back control gate $G_{N2}$ placed in the bulk substrate and separated from the channel $C_7$ by the insulating layer BOX. The transistor $T_7$ thus has two control gates: namely the conventionally used front control gate $G_{A7}$, and the back control gate $G_{N2}$ proposed by the invention, which is intended especially to be used for increasing the conduction of the transistor without having to increase the dimensions thereof.

Figure 2 aims to illustrate the various possible situations. In this Figure 2:

- the transistor $T_1$ has a back control gate $G_{P1}$ of $p^+$-type;
- the transistor $T_2$ has a back control gate $G_{N1}$ of $n^+$-type;

- the transistor $T_3$ has no back control gate;
- the transistors $T_4$-$T_6$ have a common back control gate $G_{P2}$ of p+-type; and
- the transistor $T_7$ has a back control gate $G_{N2}$ of n+-type.

As shown in Figure 2, a back control gate associated individually with a transistor may be located in the bulk substrate beneath the insulating layer so as to extend only facing the channel of the transistor (cf. transistors $T_1$, $T_2$ and $T_7$).

The back control gate may be common to a plurality of transistors, lying in the bulk substrate beneath the insulating layer under the channels of said plurality of transistors (in the case of the transistors $T_4$-$T_6$).

The back control gate is for example formed by implanting dopants beneath the insulating layer BOX.

The back control gate is isolated from the bulk substrate by a well $C_{N1}$, $C_{P1}$, $C_{N2}$, $C_{P2}$ of opposite conductivity type (n-type well $C_{N1}$, $C_{N2}$ for a p+-type back control gate $G_{P1}$, $G_{P2}$ ; p-type well $C_{P1}$, $C_{P2}$ for an n+-type back control gate $G_{N1}$, $G_{N2}$).

The well voltage is chosen so that the parasitic diode created by the electrode node between the back control gate and the well is always reverse-biased, the diode isolating the back control gate from the well and from anything that it may contain (especially other back control gates). In fact, it is of course possible to provide a well common to several back control gates of the same type.

It should be noted that, as an alternative or in addition to the wells, it is possible to provide lateral isolation regions extending, beneath the insulating layer BOX, depthwise into the bulk substrate so as to isolate the back control gate from the bulk substrate. In such a situation, the back control gate does not have to be precisely located facing the channel of a transistor.

Moreover, according to an alternative embodiment (not shown), a second insulating layer, based in the bulk substrate beneath the insulating layer BOX, may also contribute, completely or partly, to isolating a back control gate from the bulk substrate.

By biasing the back control gate of the transistor positively or negatively (typically by +0.3 V or -0.3 V), the properties of the transistor may be individually modified. In particular, the threshold voltage of the transistor may be shifted. Now, modifying the threshold voltage is equivalent to modifying the physical width of the channel of the transistor.

Thus, in the context of the invention, the physical width of the channel of the transistor is defined once and for all, but it proves possible to modify the apparent (effective) width of its channel by choosing the way in which the back control gate is driven.

A transistor with a channel of n-type conductivity and a back control gate of p-type conductivity (the back control gate is then said to have a work function) has a very high threshold voltage. This threshold voltage can be lowered by applying a positive voltage to the back control gate.

A transistor having a channel of n-type conductivity and a back control gate of n-type conductivity (the back control gate is then said not to have a work function) has a nominal threshold voltage that can be lowered by applying a positive voltage to the back control gate.

This variation in threshold voltage of the transistor via the back control gate may be formulated according to $V_{th} = V_{t0} - \alpha V_{BG}$, where $V_{th}$ represents the threshold voltage of the transistor, $V_{BG}$ the voltage applied to the back control gate, $V_{t0}$ the nominal threshold voltage (which may be shifted by the work function according to whether a back control gate of n-type or p-type is used) and $\alpha$ a factor associated with the geometry of the transistor.

The factor $\alpha$ may especially be modelled as $\alpha = 3t_{ox1}/(t_{Si}+3t_{ox2})$, where $t_{ox1}$ denotes the thickness of the dielectric layer of the gate separating the front control gate from the channel, $t_{ox2}$ denotes the thickness of the insulating layer separating the back control gate from the channel and $t_{Si}$ denotes the thickness of the thin layer.

It will therefore be understood that the type of doping of the back control gate associated with a transistor may or may not shift the nominal threshold voltage, and that the bias of the back control gate enables the threshold voltage to be adjusted.

It is thus possible to benefit from an increase in the conduction current $I_{ON}$ in the on-state of the transistor (by reducing the threshold voltage) and a reduction in the leakage current $I_{OFF}$ in the off-state of the transistor (by increasing the threshold voltage).

Thus, in the context of the invention, it is preferred to choose the transistor so that it has a physical width smaller than the physical width that this transistor would have without the implementation of the invention (in the case of a CMOS data path cell produced on a bulk substrate). Thus, the capacitance of the stage to which this transistor belongs is reduced. In such a way, the load of the preceding stage or stages is reduced.

For a constant level of conduction, it is thus possible to reduce the load of the preceding stage by around 33%.

The use of the back control gate generally makes it possible to reduce the width of the transistor by a factor of two for a constant conductance (starting from the 45 nm lithography, since the thickness ratios and the voltages are not favourable for the previous lithographies). If the width of the transistor is reduced by a factor of two, its input capacity is also reduced by this factor, but the output conductance, which may also be sought, is not improved. Thus, it is intuitively estimated that a quadratic factor ($\sqrt{2}$) is usually preferable. However, it should be noted that data path cells are optimized relative to their context and that there may be cases in which it is desirable to exclusively optimize the capacitance or the resistance.

Indeed, it is also possible to act on the back control gate of the transistor in order to benefit from an increase in the conduction current (the effective width of the channel is thus increased without the physical width being modified). Thus, it is possible to reduce the resistance (increase the conductance) of the stage to which this transistor belongs. The following stage or stages may be effectively loaded in such a manner.

Thus, it is possible to obtain an impedance reduction of around 33% at the 32 nm technology node (this reduction having to be even greater for the next-generation technologies) without having to increase the size of the transistors.

Of course, these two actions may preferably be implemented together. In such a situation, the footprint of the data path cell may be reduced by around 15 to 25%.

The following equation, drawn from article "Closed-form Expressions for Interconnection Delay, Coupling, and Crosstalk in VLSI's" by T. Sakurai, in IEEE Transactions On Electron Devices, Vol. 40, No. 1, January 1993, illustrates the propagation delay $T_v$ between an output stage and an input stage:

$$T_v = 0.1 R_{int} C_{int} + \ln\left(\frac{1}{1-v}\right)\left(R_{buf} C_{int} + R_{int} C_{buf} + R_{buf} C_{buf} + 0.4 R_{int} C_{int}\right).$$

In this equation:

- $R_{int}$ and $C_{int}$ represent the resistance and the capacitance of the electrical connection respectively, these varying depending on the lithography (32 nm in the example considered below) and on the length of the connection (between 10 nm and 10 $\mu$m in the example);
- $R_{buf}$ represents the impedance of the output stage at the entry of the electrical connection; and
- $C_{buf}$ represents the capacitance of the input stage at the other end of the electrical connection.

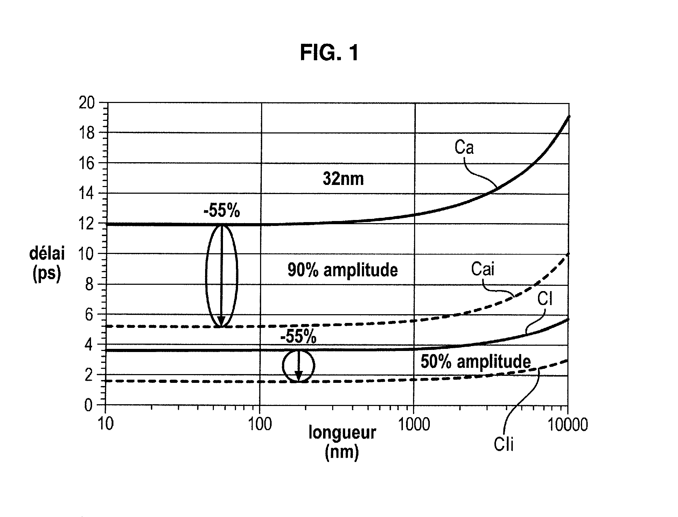

The curves Ca and Cl in Figure 1 show the propagation delay (in ps) as a function of the connection length (in nm), for propagation of 90% of the amplitude of an analogue signal and for 50% propagation of the amplitude of a digital signal, respectively.

In one exemplary embodiment of the invention, $C_{buf}$ and $R_{buf}$ are reduced by 33%. Curves Cai and Cli illustrate the substantial reduction (by around 55%) in the propagation delay for the analogue and digital situations respectively.

It will have been understood that it is possible to vary one or both of the parameters: $C_{buf}$ (via a reduction in the dimensions of the transistor) and $R_{buf}$ (via the back control gate).

Thus, at the 32 nm technology node, the speed may be approximately doubled. However, an increase in speed of around 25 to 33% may be conservatively estimated.

As indicated above, the footprint of the data path cell may be reduced by around 15 to 25%.

The invention also offers the advantage of reducing leakage and therefore power consumption. This reduction in leakage is due to the use of smaller transistors and may also be obtained by appropriately controlling the back control gate when the transistor is in the off-state (reduction in the leakage current $I_{OFF}$).

The power consumption may thus be reduced by around 25 to 33% in the on-state. It is reduced of the order of one to two decades in the off-state compared with the data path cell in conventional CMOS technology or without driving the back control gate.

It will be understood that this reduction in consumption obviously applies at a constant operating frequency insofar as smaller transistors consume less power. However, the transistors are also markedly faster and higher frequencies may be envisaged. A higher frequency does in the end entail a higher consumption but also a commensurately higher usage factor.

The invention furthermore has the benefit of allowing higher operating frequencies to be achieved. A conservative estimate is a frequency increase of around 30 to 50%.

One method of operating a transistor with a back control gate of a data path cell according to the invention consists in applying a first potential to the back control gate when the transistor is in the off-state and a second potential when the transistor is in the on-state.

More particularly, when the back control gate is in the low or off-state, for example when connected to ground, the transistor operates at low speed with low leakage. In the absence of signals, i.e. in the off-state the power consumption is reduced.

When the back control gate is in the high or on-state, for example being connected to a nominal supply voltage $V_{DD}$, the operating speed is increased.

By making an appropriate compromise between driving the back control gate and the physical dimensions of the transistor, it is possible to achieve, simultaneously, both a 20% reduction in the footprint and a 20% increase in performance. Of course, each cell may be designed to benefit from all the advantages of one or other of these parameters.

In the above description, only a single transistor of the data path cell was taken as example. In practice, all or some of the transistors of the cell may have a back control gate.

A back gate line may furthermore connect the back control gates of a plurality of transistors. In particular, a common back gate line may connect the back control gates of transistors placed along one and the same row.

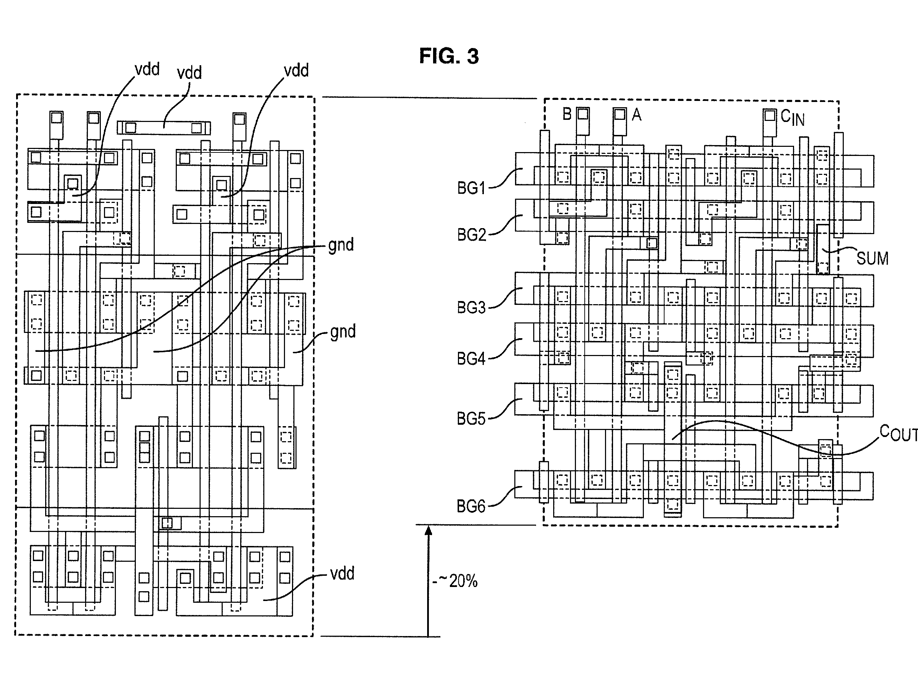

Figure 3 shows a comparison between a full-adder data path cell in bulk CMOS technology (on the left in Figure 3) and the same cell according to one possible embodiment of the invention (on the right). The transistors of the cell according to the invention are arranged in rows, a back gate line BG1-BG6 extending in the bulk substrate beneath the insulating layer along each row.

The cell according to the invention has an operating speed at least about 20% higher, has a footprint about 20% lower and a power consumption reduced by about 20% in the active mode and by more than one decade in the inactive mode.

The topology of the example shown in Figure 3 is also advantageous in that it provides a regularized configuration for limiting the aberrations and deformations caused by reducing the dimensions under the exposure wavelength of photoresist masks. This regularized configuration is based especially on a single polysilicon orientation (giving only a single dimensional tolerance in relation to the fabrication tools) and on a single polysilicon pitch (giving better control of the optical phenomena).

Furthermore, the cell consists only of bands of active zones, thereby simplifying the photolithography operations.

In the example shown in Figure 3, the transistors of any one row have the same dimensions (especially the same width). However, the invention is not limited to such a situation, rather it also covers transistors having different physical dimensions (particularly different widths) along any one row.

Moreover, each transistor (or each group of transistors, especially each row of transistors) may have a dedicated "scale factor", simply by applying a different potential to each back control gate.

It will have been understood that the invention is not limited to a data path cell according to its first aspect, but also extends to an integrated circuit comprising such a cell, to a method of driving such a cell and to a method of designing such a cell in which the physical width of at least one transistor of the cell is reduced so as to decrease the capacitance thereof and a back control gate is added to the transistor in order to increase the conductance thereof.

## Claims

1. Data path cell specifically adapted to its environment for use in an integrated circuit produced on a semiconductor-on-insulator substrate comprising a thin layer of semiconductor material separated from a bulk substrate by an insulating layer, the cell comprising an array of field-effect transistors, each transistor having, in the thin layer, a source region ($S_7$), a drain region ($D_7$) and a channel region ($C_7$) which is bounded by the source and drain regions, and further including a front gate control region ($GA_7$) formed above the channel region, **characterized in that** at least one transistor ($T_7$) has a back gate control region ($GN_2$) formed in the bulk substrate beneath the channel region, the back gate region being able to be biased so as to modify the performance characteristics of the transistor.

2. Cell according to Claim 1, in which the back gate line ($BG_1$-$BG_6$) connects the back gate regions of a plurality of transistors.

3. Cell according to Claim 2, in which the back gate line ($BG_1$-$BG_6$) extends into the bulk substrate beneath the insulating layer along a row of transistors.

4. Cell according to Claim 1, in which the back gate region is isolated from the bulk substrate by a well of opposite conductivity type.

5. Cell according to Claim 1, in which the back gate region has a conductivity of the same type as that of the channel of the transistor.

6. Integrated circuit produced on a semiconductor-on-insulator substrate comprising a data path cell according to any one of the preceding claims.

7. Method of driving a cell according to Claim 1, in which the back gate region is connected to a first potential when the transistor is in the off-state and to a second potential when the transistor is in the on-state.

8. Method of designing a data path cell in which the cell is specifically adapted to its environment for use in an integrated circuit produced on a semiconductor-on-insulator substrate comprising a thin layer of semiconductor material separated from a bulk substrate by an insulating layer, comprising the steps consisting in:

- reducing the physical width of a transistor of the cell, in order to decrease the capacitance thereof; and
- adding a back control gate to the transistor, said gate being placed in the bulk substrate, in order to increase the conductance thereof when in use in an on-state.

## FIG. 1

FIG. 2

**FIG. 3**

EP 2 363 886 A1

Europäisches
Patentamt

European
Patent Office

Office européen
des brevets

## EUROPEAN SEARCH REPORT

Application Number

EP 10 19 5783

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 112 997 B1 (LIANG MINCHANG [US] ET AL) 26 September 2006 (2006-09-26)<br>* abstract *<br>* column 5, line 19 - column 10, paragraph 24 *<br>* figures 8,9 *<br>----- | 1-8 | INV.<br>H01L27/12 |
| X | BECKETT P: "Performance characteristics of a nanoscale double-gate reconfigurable array",<br>PROCEEDINGS OF THE INTERNATIONAL SOCIETY FOR OPTICAL ENGINEERING (SPIE), SPIE, USA, vol. 7268, 1 January 2008 (2008-01-01), pages 72680E-1, XP002579039,<br>ISSN: 0277-786X<br>* the whole document *<br>----- | 1-8 | |
| X | US 6 063 686 A (MASUDA HIROO [JP] ET AL) 16 May 2000 (2000-05-16)<br>* abstract *<br>* column 6, line 36 - column 8, line 11 *<br>* column 10, line 63 - column 11, line 52 *<br>* figure 20 *<br>----- | 1-8 | |
| X | US 2003/001658 A1 (MATSUMOTO KOICHI [JP]) 2 January 2003 (2003-01-02)<br>* abstract *<br>* paragraphs [0008], [0009], [0019], [0022], [0027] *<br>----- | 1-8 | TECHNICAL FIELDS SEARCHED (IPC)<br><br>H01L |
| X | US 6 072 217 A (BURR JAMES B [US]) 6 June 2000 (2000-06-06)<br>* abstract *<br>* figures 5,6,7 *<br>----- | 1-8 | |
| | -/-- | | |

The present search report has been drawn up for all claims

| Place of search | Date of completion of the search | Examiner |
|---|---|---|
| Berlin | 18 May 2011 | Morena, Enrico |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

    .......................................................................................

& : member of the same patent family, corresponding
document

EPO FORM 1503 03.82 (P04C01)

**EP 2 363 886 A1**

Europäisches Patentamt
European Patent Office
Office européen des brevets

# EUROPEAN SEARCH REPORT

Application Number

EP 10 19 5783

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HOON CHOI ET AL: "Improved current drivability with back-gate bias for elevated source and drain structured FD-SOI SiGe MOSFET", MICROELECTRONIC ENGINEERING, ELSEVIER PUBLISHERS BV., AMSTERDAM, NL LNKD-DOI:10.1016/J.MEE.2009.03.015, vol. 86, no. 11, 1 November 2009 (2009-11-01), pages 2165-2169, XP002579041, ISSN: 0167-9317 * the whole document * ----- | 1-8 | |
| A | WO 2010/007478 A1 (UNIV YALE [US]; MA TSO-PING [US]; LEE MINJOO [US]; SUN XIAO [US]) 21 January 2010 (2010-01-21) * abstract * * figures 5,6,7,9 * ----- | 1-8 | |

TECHNICAL FIELDS
SEARCHED       (IPC)

The present search report has been drawn up for all claims

| Place of search | Date of completion of the search | Examiner |
|---|---|---|
| Berlin | 18 May 2011 | Morena, Enrico |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................................
& : member of the same patent family, corresponding document

EPO FORM 1503 03.82 (P04C01)

12

**ANNEX TO THE EUROPEAN SEARCH REPORT
ON EUROPEAN PATENT APPLICATION NO.**

EP 10 19 5783

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2011

| Patent document cited in search report | | Publication date | Patent family member(s) | | Publication date |
|---|---|---|---|---|---|
| US 7112997 | B1 | 26-09-2006 | US | 2006279333 A1 | 14-12-2006 |
| US 6063686 | A | 16-05-2000 | NONE | | |
| US 2003001658 | A1 | 02-01-2003 | WO JP TW | 0245174 A1 2002164544 A 530417 B | 06-06-2002 07-06-2002 01-05-2003 |
| US 6072217 | A | 06-06-2000 | NONE | | |
| WO 2010007478 | A1 | 21-01-2010 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. SAKURAI.** Closed-form Expressions for Interconnection Delay, Coupling, and Crosstalk in VLSI's. *IEEE Transactions On Electron Devices,* January 1993, vol. 40 (1